Europäisches Patentamt

European Patent Office

Office européen des brevets

(19)

(11) Veröffentlichungsnummer: **0 050 774**
**B1**

(12) # EUROPÄISCHE PATENTSCHRIFT

(45) Veröffentlichungstag der Patentschrift:
24.07.85

(51) Int. Cl.⁴: **H 01 L 23/46**

(21) Anmeldenummer: 81108180.1

(22) Anmeldetag: 09.10.81

(54) **Kühlkörper für Flüssigkeitskühlung von Halbleiterbauelementen.**

(30) Priorität: 29.10.80 DE 3040776

(43) Veröffentlichungstag der Anmeldung:
05.05.82 Patentblatt 82/18

(45) Bekanntmachung des Hinweises auf die Patenterteilung:
24.07.85 Patentblatt 85/30

(84) Benannte Vertragsstaaten:
DE GB SE

(56) Entgegenhaltungen:
DE - A - 2 640 000
FR - A - 1 479 193

(73) Patentinhaber: **Siemens Aktiengesellschaft, Berlin und München Wittelsbacherplatz 2, D-8000 München 2 (DE)**

(72) Erfinder: **Bahlinger, Walter, Eduard Schenkstrasse 68, D-8000 München 40 (DE)**

EP 0 050 774 B1

**Beschreibung**

Die Erfindung bezieht sich auf einen zwei Hauptflächen und Kühlkanäle, sowie einen Einlass und einen Auslass aufweisenden Kühlkörper zur Flüssigkeitskühlung von zwei Halbleiterbauelementen, von denen das eine an der einen und das andere an der anderen Hauptfläche des Kühlkörpers anliegt.

Solche Kühlkörper sind zum Beispiel in der DE-B-1 564 694 beschrieben worden. Sie werden zum Kühlen von Gleichrichter- und Thyristorsäulen eingesetzt. Hierbei muss der zwischen zwei Halbleiterbauelementen liegende Kühlkörper einen gewissen Anteil der Verlustwärme von zwei Halbleiterbauelementen abführen. Bei der bekannten Anordnung ist der Kühlkanal des das eine Halbleiterbauelement kühlenden Kühlkörpers mit dem Kühlkanal des das andere Halbleiterbauelement kühlenden Kühlkörpers parallelgeschaltet. Das heisst, dass jeder Deckel nur von der Hälfte der Flüssigkeit durchströmt wird. Die Kühlwirkung einer solchen Anordnung ist dementsprechend gering.

Der Erfindung liegt die Aufgabe zugrunde, die Kühlwirkung eines Kühlkörpers der oben bezeichneten Gattung zu verbessern.

Diese Aufgabe wird dadurch gelöst, dass der Kühlkörper aus einem zwei Hauptflächen aufweisenden, metallischen Mittelstück und zwei an den Hauptflächen des Mittelstücks anliegenden Deckeln besteht, dass die Kühlkanäle in den Deckeln vorgesehen sind, und dass die Kühlkanäle der beiden Deckel hintereinander von der gesamten Kühlflüssigkeit durchflossen werden.

Ein Kühlkörper mit Kühlkanälen ist beispielsweise auch aus der FR-A-1 479 193 bekannt. Dieser Kühlkörper dient offensichtlich jedoch nur dazu, ein einziges Halbleiterbauelement einseitig zu kühlen. Zur Lösung des dem Anmeldungsgegenstand zugrunde liegenden Problems trägt dieser Kühlkörper daher nichts bei.

Ausgestaltungen der Erfindung sind in den Unteransprüchen gekennzeichnet.

Die Erfindung wird an Hand einiger Ausführungsbeispiele in Verbindung mit den Figuren näher erläutert. Es zeigen:

Fig. 1 eine Aufsicht auf den Kühlkörper von der Einlass- und Auslassseite,

Fig. 2 die Innenansicht des linken Deckels des Kühlkörpers nach Fig. 1,

Fig. 3 die Innenansicht des rechten Deckels des Kühlkörpers nach Fig. 1 und

Fig. 4 die Innenansicht eines Deckels gemäss einem anderen Ausführungsbeispiel.

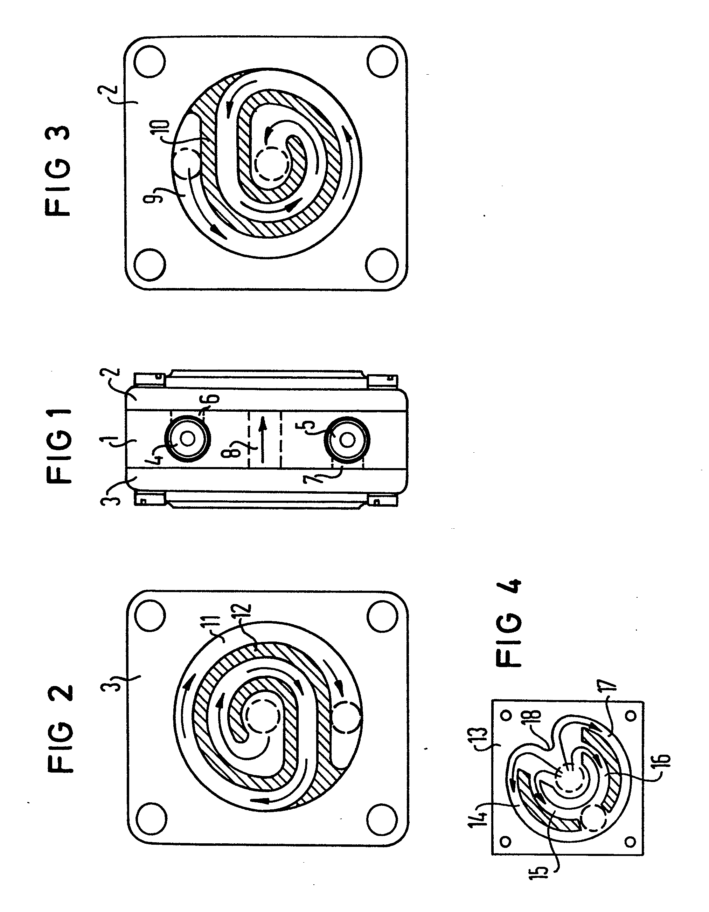

Der Kühlkörper nach Fig. 1 weist ein metallenes Mittelstück 1 mit zwei Hauptflächen auf. An der linken Hauptfläche sitzt ein Deckel 3, an der rechten Hauptfläche ein Deckel 2. Das Mittelstück 1 und die Deckel 2, 3 bestehen aus gut wärmeleitendem Metall, zum Beispiel aus Kupfer oder Aluminium. Das Mittelstück 1 trägt einen Einlass 4 und einen Auslass 5. Der Einlass 4 ist über eine erste Öffnung 6 mit dem Inneren des ersten Deckels 2 verbunden. Der Auslass 5 ist über eine zweite Öffnung 7 mit dem Inneren des linken Deckels 3 verbunden. Das Mittelstück 1 ist ferner von einer dritten Öffnung 8 durchsetzt, die die Deckel 2 und 3 miteinander verbindet.

Auf der Innenseite des Deckels 2 ist ein schneckenförmig gewundener Kanal 9 angeordnet, der durch einen Steg 10 begrenzt wird. Der Steg ist der besseren Übersicht halber schraffiert dargestellt. Der Anfang des Kanals 9 liegt der Öffnung 6 gegenüber, deren Projektion auf den Deckel 2 in Fig. 3 durch einen gestrichelten Kreis angedeutet ist. Das Ende des Kanals 9 liegt der dritten Öffnung 8 gegenüber, deren Projektion auf den Deckel 2 ebenfalls durch einen gestrichelten Kreis dargestellt ist. Der zweite, in Fig. 2 dargestellte linke Deckel 3 weist ebenfalls einen schneckenförmig gewundenen Kanal 11 auf, der durch einen Steg 12 begrenzt ist (ebenfalls schraffiert). Der Anfang des Kanals liegt der dritten Öffnung 8 gegenüber, sein Ende der zweiten Öffnung 7. Die Projektionen dieser Öffnungen auf das Innere des Deckels 3 sind wiederum durch gestrichelte Kreise angedeutet.

Tritt durch den Einlass 4 Kühlflüssigkeit ein, so fliesst sie durch die erste Öffnung 6, durch den Kanal 9 des Deckels 2 entlang der Pfeilrichtung, tritt durch die dritte Öffnung 8 aus und gelangt in den Kanal 11 des Deckels 2. Hier fliesst sie von innen nach aussen durch den Kanal 11, die zweite Öffnung 7 und tritt durch den Auslass 5 aus. Die Kanäle 9 und 11 sind also bezüglich der Strömungsrichtung hintereinandergeschaltet und jedes der zu beiden Seiten des Kühlkörpers 1 anliegenden Bauelemente wird durch die gesamte Wassermenge gekühlt. Hiermit wird, unbeschadet der Tatsache, dass das den Kanal 11 durchfliessende Wasser wärmer ist als das den Kanal 9 durchfliessende, eine gegenüber der bekannten Lösung mit parallelgeschaltetem Kühlmittelfluss verbesserte Kühlwirkung erreicht, da jeder Deckel gegenüber dieser Lösung von der doppelten Wassermenge durchflossen wird.

Die Kanäle 11 und 12 in den Deckeln 2, 3 sind vorzugsweise gleich geformt. Sie sind lediglich gegeneinander um 180° versetzt auf dem Mittelstück 1 befestigt. Zweckmässigerweise liegt dazu die beide Deckel verbindende Öffnung 8 zentrisch zu den Deckeln. Will man zum Beispiel Einlass und Auslass auf zwei benachbarten Aussenflächen des Mittelteils 1 anordnen, so muss der Deckel 2 gegenüber dem Deckel 3 lediglich um 90° verdreht montiert werden. Werden die Deckel rund ausgeführt und zum Beispiel über eine Klemmvorrichtung mit einem runden Mittelstück verbunden, so lassen sich Einlass und Auslass an beliebigen Stellen am Umfang des Mittelstücks anbringen. Die identische Form der Kanäle hat ausserdem noch den Vorteil, dass zur Herstellung ein und dasselbe Werkzeug verwendet werden kann.

Die Deckel 2 und 3 nach den Fig. 2 und 3 weisen jeweils einen einzigen, schneckenförmig gewundenen Kanal auf. Es ist jedoch auch möglich, einen Kanal in mehrere Einzelkanäle aufzuteilen. Ein solcher Deckel ist in Fig. 4 dargestellt. Als Mittelstück kann zum Beispiel das in Fig. 1 dargestellte verwendet werden. Die Kühlflüssigkeit tritt hier nach Durchlaufen des (nicht dargestellten) rechten Deckels durch die dritte Öffnung 8 in das Innere des Deckels 13 ein. Hier verteilt sich der Kühlmittelfluss auf vier einander parallelgeschaltete Teilkanäle 14, 15, 16 und 17. Anschliessend verlässt das Kühlmittel den Deckel 13 und tritt durch die Öffnung 7 aus dem Auslass 5. Auch hier wird jeder Deckel von der gesamten Flüssigkeitsmenge durchflossen und erhält gegenüber der Lösung, bei der die Deckel parallelgeschaltet sind, die doppelte Menge. Vorzugsweise sind die Kanäle des Deckels 13 so geformt, dass sich die Kühlflüssigkeit symmetrisch verteilt. Dazu ist der Deckel 13 symmetrisch zu einer durch die Mittelpunkte der Projektionen der Öffnungen 7 und 8 gehende gedachte Linie ausgebildet. Die Verteilung kann durch eine Prallnase 18 verbessert werden. Diese Prallnase erhöht auch die mechanische Stabilität des Kühlkörpers. Damit ist bei druckkontaktierten Bauelementen eine bessere Drucküberträgung gewährleistet. Der andere zum Kühlkörper gehörige Deckel kann wiederum identisch ausgebildet sein.

Der Kühlkörper lässt sich vorteilhafterweise für einen Säulenaufbau benützen, bei dem die beiden am Kühlkörper anliegenden Bauelemente auf ihrer dem Kühlkörper zugewandten Seite gleiches Potential haben. Zur Stromzuführung kann das Mittelstück dann Teil einer Stromschiene sein.

## Patentansprüche

1. Zwei Hauptflächen und Kühlkanäle (9, 11) sowie einen Einlass (4) und einen Auslass (5) aufweisender Kühlkörper zur Flüssigkeitskühlung von zwei Halbleiterbauelementen, von denen das eine an der einen und das andere an der anderen Hauptfläche des Kühlkörpers anliegt, dadurch gekennzeichnet, dass der Kühlkörper aus einem zwei Hauptflächen aufweisenden, metallischen Mittelstück (1) und zwei an den Hauptflächen des Mittelstücks (1) anliegenden Deckeln (2, 3) besteht, dass die Kühlkanäle (9, 11) in den Deckeln (2, 3) vorgesehen sind, und dass die Kühlkanäle (9, 11) der beiden Deckel (2, 3) hintereinander von der gesamten Kühlflüssigkeit durchflossen werden.

2. Kühlkörper nach Anspruch 1, gekennzeichnet durch die Merkmale:

a) Der Einlass (4) und der Auslass (5) sitzen im Mittelstück (1);

b) mit dem Einlass (4) ist eine in die erste Hauptfläche mündende erste Öffnung (6) verbunden;

c) mit dem Auslass (5) ist eine in die zweite Hauptfläche mündende zweite Öffnung (7) verbunden;

d) die erste und zweite Hauptfläche ist durch eine dritte Öffnung (8) verbunden;

e) die Hauptflächen des Mittelstücks und die zugeordneten Deckel (2, 3) sind miteinander flüssigkeitsdicht verbunden;

f) die Kanäle (9, 11) haben eine derartige Gestalt, dass der Anfang des Kanals (9) des ersten Deckels (2) der ersten Öffnung (6) und sein Ende der dritten Öffnung (8) gegenüberliegt und dass der Anfang des Kanals (11) des zweiten Deckels (3) der dritten Öffnung (8) und sein Ende der zweiten Öffnung (7) gegenüberliegt.

3. Kühlkörper nach Anspruch 2, dadurch gekennzeichnet, dass die Kanäle (9, 11) schneckenförmig gewunden sind.

4. Kühlkörper nach Anspruch 2, dadurch gekennzeichnet, dass die Kanäle in eine Anzahl von parallelen Teilkanälen (14, 15, 16, 17) unterteilt sind.

5. Kühlkörper nach Anspruch 4, dadurch gekennzeichnet, dass die Kanäle bezüglich einer die Mittelpunkte von erster (6) und dritter Öffnung (8) beziehungsweise zweiter (7) und dritter Öffnung (8) verbindenden Linie symmetrisch ausgebildet sind.

6. Kühlkörper nach einem der Ansprüche 1 bis 5, dadurch gekennzeichnet, dass die Kanäle (9, 11) beider Deckel (2, 3) die gleiche Form haben.

7. Kühler nach einem der Ansprüche 1 bis 6, dadurch gekennzeichnet, dass die Projektion der dritten Öffnung (8) auf die Deckel (2, 3) zentrisch im Deckel liegt.

8. Kühlkörper nach einem der Ansprüche 1 bis 7, dadurch gekennzeichnet, dass das Mittelstück (1) Teil einer Stromschiene ist.

**Claims**

1. A cooling body having two main faces and cooling channels (9, 11) and one inlet (4) and one outlet (5) for the liquid cooling of two semiconductor components, of which one is adjacent to one main face of the cooling body and the other to the other main face of the cooling body, characterised in that the cooling body consists of a metallic central portion (1) which has two main faces, and two covers (2, 3) which adjoin the main faces of the central portion (1); that the cooling channels (9, 11) are arranged in the covers (2, 3); and that the cooling channels (9, 11) of the two covers (2, 3) are traversed in series by the whole of the cooling liquid.

2. A cooling body as claimed in Claim 1, characterised by the features:

a) the inlet (4) and the outlet (5) are located in the central portion (1);

b) the inlet (4) is connected to a first opening (6) which opens at the first main face;

c) the outlet (5) is connected to a second opening (7) which opens at the second main face;

d) the first and second main faces are connected by a third opening (8);

e) the main faces of the central portion and the assigned covers (2, 3) are connected to one another in liquid tight fashion;

f) the channels (9, 11) are so shaped that the start of the channel (9) of the first cover (2) lies opposite the first opening (6), and its end lies opposite the third opening (8), and that the start of the channel (11) of the second cover (3) lies opposite the third opening (8) and its end lies opposite the second opening (7).

3. A cooling body as claimed in Claim 2, characterised in that the channels (9, 11) are coiled in spiral fashion.

4. A cooling body as claimed in Claim 2, characterised in that the channels are subdivided into a number of parallel subsidiary channels (14, 15, 16, 17).

5. A cooling body as claimed in Claim 4, characterised in that the channels are designed to be symmetrical relative to a line which links the centre points, of the first opening (6) and third opening (8), and the second opening (7) and third opening (8).

6. A cooling body as claimed in one of Claims 1 to 5, characterised in that the channels (9, 11) of both covers (2, 3) have the same shape.

7. A cooling body as claimed in one of Claims 1 to 6, characterised in that the projection of the third opening (8) on to the covers (2, 3) is located centrally of the cover.

8. A cooling body as claimed in one of Claims 1 to 7, characterised in that the central portion (1) forms part of a busbar.

**Revendications**

1. Corps de refroidissement comportant deux surfaces principales et des canaux de refroidissement (9, 11) ainsi qu'une admission (4) et une sortie (5) et servant à refroidir, au moyen d'un liquide, deux composants à semiconducteurs, dont l'un est appliqué contre une surface principale du corps de refroidissement et dont l'autre est appliqué contre l'autre surface principale de ce corps, caractérisé par le fait que le corps de refroidissement est constitué par un élément central métallique (1) comportant deux surfaces principales et par deux couvercles (2, 3) s'appliquant contre les surfaces principales de l'élément central (1), et que les canaux de refroidissement (9, 11) sont prévus dans les couvercles (2, 3) et que les canaux de refroidissement (9, 11) des deux couvercles (2, 3) sont parcourus en série par le même liquide de refroidissement.

2. Corps de refroidissement selon la revendication 1, remarquable par les caractéristiques:

a) l'admission (4) et la sortie (5) sont situées dans l'élément central (1);

b) une première ouverture (6) débouchant dans la première surface principale est reliée à l'admission (4);

c) une seconde ouverture (7) débouchant dans la seconde surface principale est reliée à la sortie (5);

d) la première et la seconde surfaces principales sont reliées par une troisième ouverture (8);

e) les surfaces principales de l'élément central et les couvercles associés (2, 3) sont reliés entre eux d'une manière étanche au liquide;

f) les canaux (9, 11) possèdent une forme telle que le début du canal (9) du premier couvercle (2) est en vis-à-vis de la première ouverture (6) et que son extrémité est en vis-à-vis de la troisième ouverture (8), et que le début du canal (11) du second couvercle (3) est en vis-à-vis de la troisième ouverture (8) et que son extrémité est en vis-à-vis de la seconde ouverture (7).

3. Corps de refroidissement suivant la revendication 2, caractérisé par le fait que les canaux (9, 11) sont enroulés avec une forme spiralée.

4. Corps de refroidissement suivant la revendication 2, caractérisé par le fait que les canaux sont subdivisés en un nombre de canaux partiels parallèles (14, 15, 16, 17).

5. Corps de refroidissement suivant la revendication 4, caractérisé par le fait que les canaux sont disposés symétriquement par rapport à une droite reliant les centres de la première ouverture (6) et de la troisième ouverture (8) ou de la seconde ouverture (7) et de la troisième ouverture (8).

6. Corps de refroidissement suivant l'une des revendications 1 à 5, caractérisé par le fait que les canaux (9, 11) de couvercle (2, 3) possèdent la même forme.

7. Corps de refroidissement suivant l'une des revendications 1 à 6, caractérisé par le fait que la projection de la troisième ouverture (8) sur les couvercles (2, 3) se situe au centre des couvercles.

8. Corps de refroidissement suivant l'une des revendications 1 à 7, caractérisé par le fait que l'élément central (1) fait partie d'une barre conductrice.

## FIG 2

## FIG 1

## FIG 3

## FIG 4

0 050 774